# EUROPEAN PATENT APPLICATION

(11) **EP 4 840 545 A1**
(43) Date of publication of application: **18.11.2026**
(21) Application number: 24925596.9
(22) Date of filing: 26.11.2024
(51) Int. Cl.: B01L 3/00, B81C 1/00

(54) **MICROFLUIDIC CHIP MANUFACTURING METHOD**

(30) Priority: 19.02.2024 CN 202410182835
(71) Applicant: LC-Biotechnologies (Hangzhou) Co., Ltd., Hangzhou, Zhejiang 310000 (CN)
(72) Inventor: ZHANG, Huigang, Hangzhou, Zhejiang 310000 (CN); LI, Lulu, Hangzhou, Zhejiang 310000 (CN); LANG, Qiulei, Hangzhou, Zhejiang 310000 (CN)
(74) Representative: Dai, Simin
(86) International application number: PCT/CN2024/134475
(87) International publication number: WO 2025/175858

(57) **Abstract**

The present disclosure relates to the technical field of microfluidic chips, and particularly relates to a method for manufacturing a microfluidic chip. The method comprises the following steps: S1, providing the following materials: an exposure devic (7), a chip base (1), a chip pressing plate (2), and a slide (3); pressing the slide (3) on the chip base (1) by means of the chip pressing plate (2), and enabling an enclosed molding space (6) to be formed between the chip base (1) and the slide (3), the chip pressing plate (2) being provided with an opening at a position corresponding to the molding space (6), and the chip base (1) being provided with a liquid inlet channel (11) and a liquid outlet channel (12) which are communicated with the molding space (6); S2, cleaning the slide (3): introducing a cleaning reagent into the molding space (6) via the liquid inlet channel (11), and the cleaning reagent flowing through the slide (3) to clean the slide (3); S3, introducing a photosensitive resin; and S4, curing and molding: curing and molding the photosensitive resin irradiated by the exposure devic (7) to form barriers (5), and the barriers enclosing a main flow channel (51), branch flow channels (52), and reaction units (53). The microfluidic chip has a short manufacturing cycle and good universality.

## Description

### CROSS-REFERENCE TO RELATED APPLICATIONS

### TECHNICAL FIELD

The present disclosure relates to the technical field of microfluidic chips, and in particular to, a method for manufacturing a microfluidic chip.

### BACKGROUND

A microfluidic chip plays an important role in some of the most cutting-edge technological developments in the fields of biology, chemical engineering, and medical detection. The microfluidic chip is also commonly referred to as a biochip or a bioarray, also known as a protein chip or a gene chip. These chips originated from the combination of Deoxyribonucleic Acid (DNA) hybridization probe technology and semiconductor industry technology. The biochip, based on the principle of specific interactions between biomolecules, integrates a biochemical analysis process on a chip surface to achieve high-throughput and rapid detection of DNA, Ribonucleic Acid (RNA), polypeptides, proteins, and other biological components. A large number of probe molecules are fixed on a support, and then hybridized with fluorescently labeled DNA or other sample molecules (such as proteins, factors, or small molecules). Quantitative and sequence information of the sample molecules is obtained by detecting the hybridization signal intensity of each probe molecule.

Existing methods for manufacturing a microfluidic chip generally use corrosion etching on an ordinary silicon-based chip to form a main flow channel, branch flow channels, and reaction units, and finally form the chip. The disadvantages of the corrosion-based manufacturing methods are that, first, a manufacturing cycle is long, typically requiring 3 to 6 months; and second, a mask used in this corrosion etching process is generally a fixed mask. After the mask is manufactured, its pattern cannot be changed, so the universality is poor, and thus there is still a need for improvement.

### SUMMARY

In order to solve at least one technical problem mentioned in the background, an objective of the present disclosure is to provide a method for manufacturing a microfluidic chip.

To achieve the above objective, the present application provides the following technical solutions:
The method for manufacturing a microfluidic chip includes:
S1, the following materials are provided: an exposure devic, a chip base, a chip pressing plate, and a slide. The slide is pressed on the chip base by the chip pressing plate, and an enclosed molding space is formed between the chip base and the slide. The chip pressing plate is provided with an opening at a position corresponding to the molding space. The chip base is provided with a liquid inlet channel and a liquid outlet channel in fluid communication with the molding space.
S2, the slide is provided: a cleaning reagent is injected into the molding space through the liquid inlet channel, and is flowed through the slide to clean the slide.
S3, a photosensitive resin is introduced: after the cleaning is completed, the photosensitive resin is injected into the molding space through the liquid inlet channel to fill the molding space.
S4, curing and molding are performed: the exposure devic is turned on, and a first photomask is output, and the exposure devic irradiates the photosensitive resin in the molding space through the first photomask for a period of time. The photosensitive resin irradiated by the exposure devic is cured and molded to form barriers, and a main flow channel, branch flow channels, and reaction units are formed by being surrounded by the barriers.
S5, the slide is cleaned: the cleaning reagent is introduced into the molding space through the liquid inlet channel, and the cleaning reagent is flowed through the slide to clean the slide, so as to flush out the photosensitive resin remaining in the molding space;
S6, a Controlled Pore Glass (CPG) carrier is cured, including:
S61, the photosensitive resin is injected into a hole-forming space through the liquid inlet channel.
S62, the exposure devic is turned on, and a second photomask is output. The second photomask is configured to cooperate with the exposure devic to irradiate and cause the photosensitive resin to be cured and molded at an outlet side of the reaction unit to form step barriers. The height of the step barrier is lower than the height of the barrier.
S63, the slide is cleaned, and the cleaning reagent is introduced into the molding space through the liquid inlet channel to flush out the photosensitive resin remaining in the molding space;
S64, the CPG carrier is filled: a CPG mixed reagent is introduced into the molding space through the liquid inlet channel, so that the CPG mixed reagent enters the reaction unit.
S65, the photosensitive resin is introduced into the molding space through the liquid inlet channel, so that the photosensitive resin enters the reaction unit.
S66, the exposure devic is turned on and a third photomask is output. The third photomask is configured to cooperate with the exposure devic to irradiate and cause the photosensitive resin loaded with the CPG carrier to be cured and molded in the reaction unit.
S67, the slide is cleaned, and the cleaning reagent is introduced into the molding space through the liquid inlet channel to flush out the photosensitive resin and the CPG carrier remaining in the molding space, thereby completing the curing of the CPG carrier.

As an optional embodiment of the present disclosure, in step S1, an annular sealing ring is further provided, the sealing ring is pressed between the chip base and the chip pressing plate, and the molding space is formed by being surrounded by the sealing ring between the chip base and the chip pressing plate.

As an optional embodiment of the present disclosure, in step S65, an introduced photosensitive resin is susceptible to dissolution by acetonitrile.

As an optional embodiment of the present disclosure, the height of the step barrier is greater than one CPG and less than 5 µm.

As an optional embodiment of the present disclosure, in step S66, the photosensitive resin is cured and molded into a horizontal sheet shape, a vertical sheet shape, or a grid shape.

As an optional embodiment of the present disclosure, in step S66, the photosensitive resin is cured into a multi-layer horizontal sheet shape, including: the curing of an underlying photosensitive resin and the CPG carrier is completed through step S65 and step S66 to form a cured bottom layer. Step S65 and step S66 are repeated to perform sequential layer-by-layer curing on the cured bottom layer.

As an optional embodiment of the present disclosure, the CPG carrier is at least one of microporous glass beads and microporous magnetic beads.

Compared with the prior art, the present disclosure has the following advantages:
First, the present solution relies on the photosensitive resin cooperating with irradiation from the exposure devic to cure and form the main flow channel, the branch flow channels, and the reaction units. This process cycle is typically 0.1 to 0.3 hours. Compared with a chip manufactured by a traditional corrosion etching manner, which has a manufacturing cycle of 3 to 6 months, the manufacturing cycle is significantly reduced.
Second, the present solution is a photocuring process, and a mask used is a digital photomask. For this mask, the pattern of the mask may be subjected to operations such as modification by a user as needed, thereby enabling customized manufacturing of microfluidic chips with desired throughputs according to user requirements. Compared with a fixed mask used in the traditional corrosion etching process, the universality is better.

In addition, the present solution further loads the CPG carrier in the reaction units of the manufactured chip. Owing to the porous structure of the CPG carrier, improved fluid flow is achieved. In conventional microfluidic chips, reagent flows on a plane of a chip carrier, and the reagent adjacent to the surface of the carrier remains stagnant. Many immobilized substances, such as oligonucleotides and DNA, have very small spatial dimensions and are located near the surface of the carrier. This results in insufficient reagent exchange, which is a contributing factor to the low reaction efficiency and insufficient sensitivity of the chip. The chip carrier of the present disclosure is a CPG microporous glass bead. Reactants are located within pores, and the reagent flowing through the micropores undergoes more sufficient exchange, resulting in higher reaction efficiency.

### BRIEF DESCRIPTION OF THE DRAWINGS

FIG. 1 is a schematic diagram illustrating a structure of the present disclosure;
FIG. 2 is a cross-sectional view of the present disclosure;
FIG. 3 is an exploded view of the present disclosure;
FIG. 4 is a schematic diagram illustrating a structure of the chip base;
FIG. 5 is a partial enlarged view of FIG. 4; and
FIG. 6 is an enlarged view of portion A in FIG. 5.

### DETAILED DESCRIPTION

Hereinafter, the technical solutions of the embodiments of the present disclosure will be explained and described with reference to the accompanying drawings. However, the following embodiments are merely preferred embodiments of the present disclosure and are not exhaustive. Other embodiments obtained by those skilled in the art based on the embodiments of the implementation approaches, without making inventive efforts, all fall within the protection scope of the present disclosure.

In the following description, terms such as 'inner', 'outer', 'upper', 'lower', 'left', 'right', or the like, which indicate orientation or positional relationships, are merely for convenience in describing and simplifying the embodiments, and are not to indicate or imply that an apparatus or an element referred to must have a particular orientation, or be constructed and operated in a particular orientation. Therefore, these terms are not to be construed as limitations to the present disclosure.

### Embodiment 1

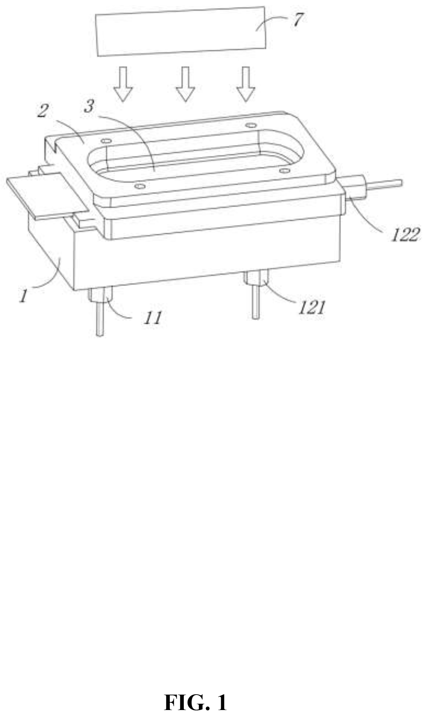

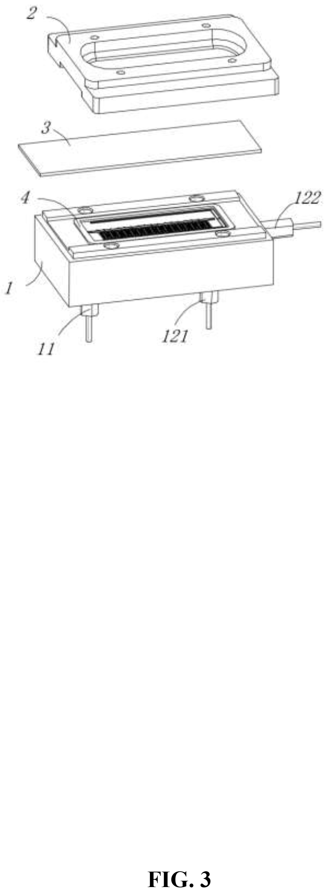

As shown in FIGs. 1 to 6, in this embodiment, a method for manufacturing a microfluidic chip is provided, which includes the following steps:
S1, the following materials may be provided: an exposure devic 7, a chip base 1, a chip pressing plate 2, a slide 3, and an annular sealing ring 4. The exposure devic 7 may be a Digital Light Processing (DLP) exposure devic, and is preferably a desktop DLP exposure devic, which may be configured to set a wavelength output as needed.

The slide 3 is pressed on the chip base 1 by the chip pressing plate 2, thereby forming an enclosed molding space 6 between the chip base 1 and the slide 3. Specifically, the sealing ring 4 is padded on a top surface of the chip base 1, then the slide 3 is pressed on the sealing ring 4, and finally the chip pressing plate 2 is pressed on the slide 3 and the chip pressing plate 2 is fixed to the chip base 1. At this time, the top surface of the chip base 1, the bottom surface of the slide 3, and the inner peripheral wall of the sealing ring 4 together enclose to form the enclosed molding space 6.

As shown in FIG. 1, the exposure devic 7 irradiates from top to bottom. To allow light to irradiate a region of the molding space 6. In this embodiment, the chip pressing plate 2 is provided with an opening at a position corresponding to the molding space 6. In a vertical projection, a range of the opening of the chip pressing plate 2 is at least greater than a range of the molding space 6.

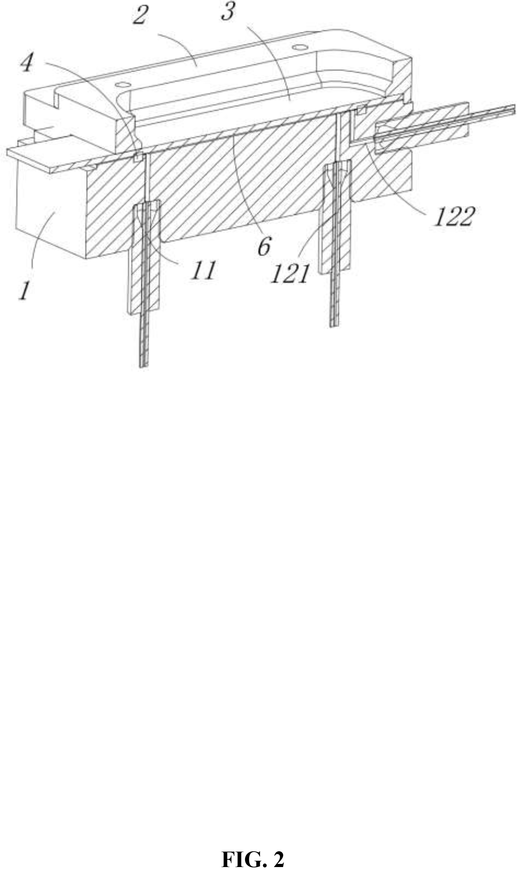

As shown in FIG. 2, the chip base 1 is provided with a liquid inlet channel 11 and a liquid outlet channel 12 in fluid communication with the molding space 6. The liquid inlet channel 11 and the liquid outlet channel 12 are arranged at two end positions of the molding space 6. To better discharge reagents or solutions, the liquid outlet channel 12 may be provided in two sets, which are respectively designated as a first liquid outlet channel 121 and a second liquid outlet channel 122 for distinction.

The liquid inlet channel 11 is mainly configured to allow various reagents to flow into the molding space 6. The liquid outlet channel 12 is configured to discharge the reagents from the molding space 6.

In this embodiment, the slide 3 may be an injection-molded transparent plate made of Polypropylene (PP), Polycarbonate (PC), or the like.

S2, the slide 3 may be cleaned: a cleaning reagent is introduced into the molding space 6 through the liquid inlet channel 11, then the reagent flows out through the liquid outlet channel 12, and such flushing is repeated 3 to 5 times. The cleaning reagent flows through the slide 3 to clean the slide 3 and the interior of the molding space 6. In this way, some impurities in the molding space 6 are cleaned off.

S3, a photosensitive resin may be introduced: after the cleaning is completed, the photosensitive resin is injected into the molding space 6 through the liquid inlet channel 11. The excess photosensitive resin flows out through the liquid outlet channel 12 until the molding space 6 is filled with the photosensitive resin.

S4, curing and molding may be performed: the exposure devic 7 is turned on, and a first photomask is output. It should be understood that a pattern of the first photomask is substantially consistent with a pattern of a microfluidic chip to be molded. The photomask refers to a digital photomask.

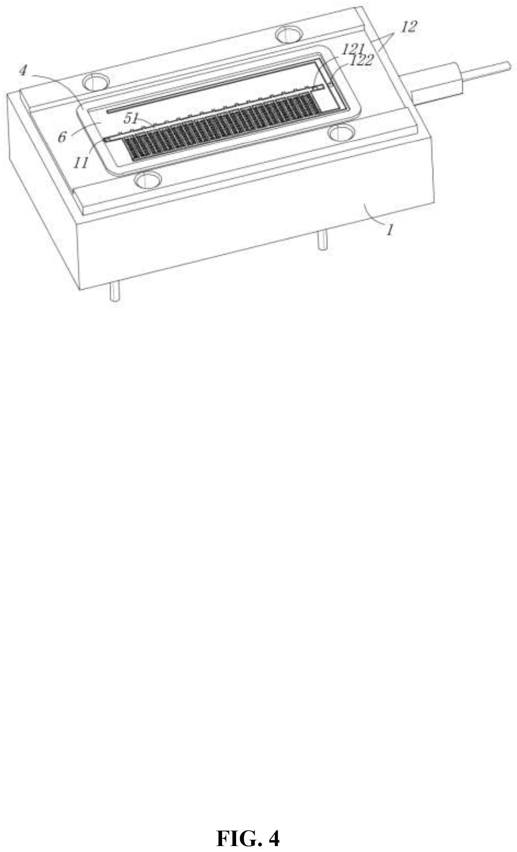

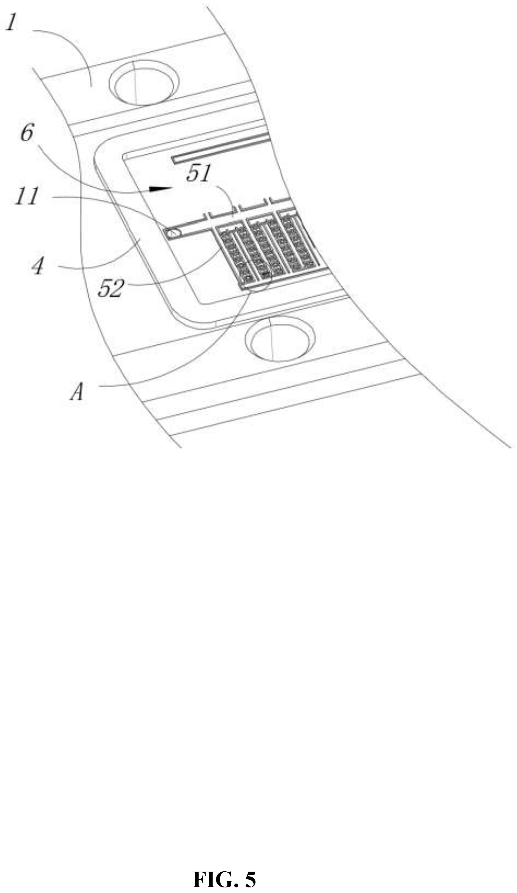

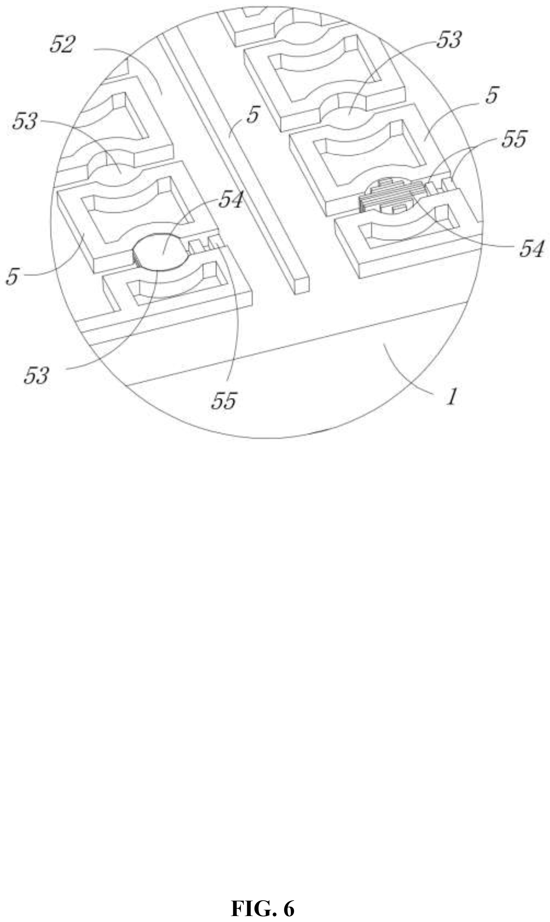

The exposure devic 7 irradiates the photosensitive resin in the molding space 6 through the first photomask for several seconds. The photosensitive resin irradiated by the exposure devic 7 is cured and molded to form barriers 5, while the photosensitive resin in the molding space 6 that is not irradiated remains in an uncured liquid state. As shown in FIG. 5 and FIG. 6, a main flow channel 51, branch flow channels 52, and reaction units 53 are formed by being surrounded by the barriers 5. It should be understood that the positions and shapes of the main flow channel 51, the branch flow channels 52, and the reaction units 53 are formed by being surrounded by the barriers 5, which are determined by the pattern of the first photomask. A user may design the pattern of the first photomask as needed. As shown in FIGs. 4 to 6, a distribution diagram of the main flow channel 51, the branch flow channels 52, and the reaction units 53 is provided. It is worth noting that only a partial structure is schematically shown in this figure, and it does not represent a graphic of an entire chip.

The preliminary manufacturing of the microfluidic chip is substantially completed through step S4. Next, the chip is cleaned as follows:

S5, the slide 3 may be cleaned: the cleaning reagent is introduced into the molding space 6 through the liquid inlet channel 11. The cleaning reagent flows along the main flow channel 51, the branch flow channels 52, and the reaction units 53, through the slide 3 to clean the slide 3 and the interior of the molding space 6, to flush out the photosensitive resin remaining in the molding space 6. Specifically, the uncured photosensitive resin remaining in the main flow channel 51, the branch flow channels 52, and the reaction units 53 is flushed out. The flushing may be repeated 3 to 5 times.

It may be seen that, for forming the main flow channel 51, the branch flow channels 52, and the reaction units 53 by curing and molding the photosensitive resin with irradiation from the exposure devic 7, the process cycle is typically 0.1 to 0.3 hours. Compared to manufacturing a chip by a traditional corrosion etching manner (the manufacturing cycle of which is 3 to 6 months), the manufacturing cycle is significantly reduced.

Second, the present solution is a photocuring process, and the mask used is the digital photomask. For this mask, the pattern of the mask may be subjected to operations such as modification by the user as needed, thereby enabling customized manufacturing of microfluidic chips with desired throughputs according to user requirements. Compared with a fixed mask used in the traditional corrosion etching process, the universality is better.

### Embodiment 2

In this embodiment, the microfluidic chip is further processed based on Embodiment 1 to load a Controlled Pore Glass (CPG) carrier into the reaction units 53 of the microfluidic chip. The CPG carrier, i.e., microporous glass beads, which are a commonly used solid-phase carriers. Alternatively, the CPG carrier may also be microporous magnetic beads. A CPG with a micropore diameter of 50 to 300 nm may be used. Its loading capacity is typically 100 µmol/g to 25 µmol/g, and it is dispersed into a CPG suspension (i.e., a CPG mixed reagent) for later use.

Specifically, the following steps are further included after step S5:
S6, the CPG carrier may be cured, including the following steps:
S61, the photosensitive resin may be injected into a hole-forming space through the liquid inlet channel 11. The photosensitive resin flows along the main flow channel 51 and the branch flow channel 52 into the reaction unit.
S62, the exposure devic 7 may be turned on, and a second photomask may be output. It should be understood that, as shown in FIG. 6, a pattern of the second photomask is adapted to the reaction unit 53 and is configured to cooperate with irradiation from the exposure devic 7 to cure and mold the photosensitive resin at an outlet side of the reaction unit 53 to form step barriers 55. The step barrier 55 here is also a barrier, except that its height is lower than the height of the barrier 5 of the reaction unit 53 previously mentioned. That is, the height of the step barrier 55 is lower than the height of the barrier 5. Preferably, the height of the step barrier 55 is greater than one CPG and less than 5 µm, where greater than one CPG may be understood as greater than the diameter of one CPG.

The step barrier 55 is formed at the outlet side of the reaction unit 53 so that, when the CPG mixed reagent is subsequently introduced, the step barrier 55 may block the CPG mixed reagent at the outlet side of the reaction unit 53. This allows a portion of the CPG mixed reagent to be enriched in the reaction unit 53 for binding with the subsequent photosensitive resin.

Conversely, if the step barrier 55 is not provided, when the photosensitive resin is subsequently introduced, the CPG may be flushed out. This causes the CPG to be scarce or even unable to remain in the reaction unit 53.

S63, the slide 3 may be cleaned. The cleaning reagent may be introduced into the molding space 6 through the liquid inlet channel 11 to flush out the photosensitive resin remaining in the molding space 6. The flushing may be repeated 3 to 5 times.

S64, the CPG carrier may be filled: the CPG mixed reagent is introduced into the molding space 6 through the liquid inlet channel 11, and the CPG mixed reagent flows along the main flow channel 51 and the branch flow channel 52 into the reaction unit 53.

S65, the photosensitive resin may be introduced into the molding space 6 through the liquid inlet channel 11 to allow the photosensitive resin to enter the reaction unit 53.

S66, the exposure devic 7 may be turned on, and a third photomask may be output. The third photomask is mainly configured to be adapted to the reaction unit 53. The third photomask is configured to cooperate with irradiation from the exposure devic 7 to cure and mold the photosensitive resin together with the CPG carrier in the reaction unit 53 to form a carrier part 54.

It is worth noting that, in this embodiment, the carrier part 54 may be fixedly molded in all the reaction units 53, as shown in FIG. 6. Alternatively, the carrier part 54 may be fixedly molded in only one or some of the reaction units 53.

The carrier part 54 formed by curing the CPG carrier together with the photosensitive resin may have various shapes, such as a multi-layer horizontal sheet shape (as shown on the left side of FIG. 6), a multi-row vertical sheet shape (as shown on the right side of FIG. 6), or a grid shape.

For example, taking the carrier part 54 formed into the multi-layer horizontal sheet shape, its formation manner is as follows:
First, a bottom layer of the carrier part 54 is formed. Specifically, the curing of the photosensitive resin and the CPG carrier in the bottom layer is completed through steps S65 and S66 to form a cured bottom layer. Then, steps S65 and S66 are repeatedly performed to sequentially stack and cure on the cured bottom layer, thereby forming the multi-layer horizontal sheet shape of the carrier part 54.

S67, the slide 3 may be cleaned. The cleaning reagent may be introduced into the molding space 6 through the liquid inlet channel 11 to flush out the photosensitive resin and the CPG carrier remaining in the molding space 6, thereby completing the curing of the CPG carrier.

The microfluidic chip obtained at this time is a chip loaded with the CPG carrier in the reaction unit 53. Grafting points of a carrier of a traditional microfluidic chip (i.e., a biochip) are all on a surface of the reaction unit 53 of the chip. Grafting sites are generated by silanization, and the size of the surface area directly determines the unit loading capacity.

The basic principle of a silanization reaction is that hydroxyl groups formed by hydrolysis of siloxane bonds react with hydroxyl groups on a chip surface in a dehydration condensation reaction, thereby coupling functionalized silanes on the chip surface as grafting sites for a next reaction.

Currently, the planar region loading capacity of the reaction unit of the biochip, with a diameter of 50 µm and a height of 15 µm, is generally less than 10^-1 to 10^-2 fmol. As the loading capacity of the biochip becomes increasingly larger, from 1K to 1000K levels, the corresponding unit loading capacity is lower. This low loading capacity severely affects the quantity of immobilized oligonucleotides, complementary DNA (cDNA), genomic DNA, polypeptides, antibodies, and antigens on the biochip, thereby greatly reducing the detection range and reliability. In particular, chips in fields such as synthesis, detection, or the like, have high requirements for a unit carrier concentration.

A chip loaded with the CPG carrier provided in the present disclosure has a higher loading capacity. The loading capacity of the reaction unit 53 of the chip is >10^1 to 10^3 that of the silanization loading capacity of the same area. For example, the reaction unit 53 has a diameter of ϕ50 µm and a height of 15 µm, the CPG has a loading capacity of 50 µmol/g, a density of 0.6×10^-12 g/µm³, an effective filling rate of 10%, and a unit loading capacity of 80 fmol. The reaction unit 53 of a general biochip has a diameter of 50 µm and a height of 15 µm, and the loading capacity is generally less than 10^-1 fmol. This increases the loading capacity of the chip unit, and directly increases the quantity of immobilized oligonucleotides, cDNA, genomic DNA, polypeptides, antibodies, and antigens, the detection range and flux, improving reaction sensitivity, thereby allowing higher throughput to be possible. By increasing or decreasing the time and number of times of photocuring, the loading capacity of the reaction unit 53 may increase or decrease an effective filling rate of the CPG according to reaction requirements, thereby achieving adjustable unit loading capacity.

Owing to the porous structure of the CPG carrier, improved fluid flow is achieved. In conventional microfluidic chips, the reagent flows on a plane of a chip carrier, and the reagent adjacent to the surface of the carrier remains stagnant. Many immobilized substances, such as oligonucleotides and DNA, have very small spatial dimensions and are located near the surface of the carrier. This results in insufficient reagent exchange, which is a contributing factor to the low reaction efficiency and insufficient sensitivity of the chip. The chip carrier of the present invention is a CPG controlled pore glass bead. Reactants are located within the pores, and the reagents flowing through the micropores undergo more complete exchange, resulting in higher reaction efficiency.

Additionally, in step S65, an introduced photosensitive resin may also be susceptible to dissolution by acetonitrile. This allows an acetonitrile reagent to be subsequently introduced to flush out the carrier part 54 in the reaction unit 53, and thus the carrier part 54 may be reused.

For those skilled in the art, it is apparent that the present disclosure is not limited to the details of the exemplary embodiments described above, and that the present disclosure can be implemented in other specific forms without departing from the spirit or essential characteristics of the present disclosure. Therefore, from any point of view, the embodiments should be regarded as exemplary and non-limiting. The scope of the present disclosure is defined by the appended claims rather than the above description, and thus is intended to encompass all changes that fall within the meaning and range of equivalents of the claims within the present disclosure.

## Claims

1. A method for manufacturing a microfluidic chip, comprising:
S1, providing the following materials: an exposure devic, a chip base, a chip pressing plate, and a slide; pressing the slide on the chip base by the chip pressing plate, and forming an enclosed molding space between the chip base and the slide; providing the chip pressing plate with an opening at a position corresponding to the molding space; providing the chip base with a liquid inlet channel and a liquid outlet channel in fluid communication with the molding space;
S2, cleaning the slide: introducing a cleaning reagent into the molding space through the liquid inlet channel, and flowing the cleaning reagent through the slide to clean the slide;
S3, introducing a photosensitive resin: after the cleaning is completed, injecting the photosensitive resin into the molding space through the liquid inlet channel to fill the molding space;
S4, curing and molding: turning on the exposure devic and outputting a first photomask, and performing irradiation by the exposure devic through the first photomask on the photosensitive resin in the molding space for a period of time, wherein the photosensitive resin irradiated by the exposure devic is cured and molded to form barriers, and a main flow channel, branch flow channels, and reaction units are formed by being surrounded by the barriers;
S5, cleaning the slide: introducing the cleaning reagent into the molding space through the liquid inlet channel, and flowing the cleaning reagent through the slide to clean the slide, so as to flush out the photosensitive resin remaining in the molding space;
S6, curing a CPG carrier, including:
S61, injecting the photosensitive resin into a hole-forming space through the liquid inlet channel;
S62, turning on the exposure devic and outputting a second photomask, the second photomask being configured to cooperate with the exposure devic to irradiate and cause the photosensitive resin to be cured and molded at an outlet side of the reaction unit to form step barriers; wherein the height of the step barrier is lower than the height of the barrier;
S63, cleaning the slide, and introducing the cleaning reagent into the molding space through the liquid inlet channel to flush out the photosensitive resin remaining in the molding space;
S64, filling the CPG carrier: introducing a CPG mixed reagent into the molding space through the liquid inlet channel, so that the CPG mixed reagent enters the reaction unit;
S65, introducing the photosensitive resin into the molding space through the liquid inlet channel, so that the photosensitive resin enters the reaction unit;
S66, turning on the exposure devic and outputting a third photomask, the third photomask being configured to cooperate with the exposure devic to irradiate and cause the photosensitive resin loaded with the CPG carrier to be cured and molded in the reaction unit;
S67, cleaning the slide, and introducing the cleaning reagent into the molding space through the liquid inlet channel to flush out the photosensitive resin and the CPG carrier remaining in the molding space, thereby completing the curing of the CPG carrier.

2. The method for manufacturing a microfluidic chip according to claim 1, wherein in step S1, an annular sealing ring is further provided, the sealing ring is pressed between the chip base and the chip pressing plate, and the molding space is formed by being surrounded by the sealing ring between the chip base and the chip pressing plate.

3. The method for manufacturing a microfluidic chip according to claim 1, wherein in step S65, an introduced photosensitive resin is susceptible to dissolution by acetonitrile.

4. The method for manufacturing a microfluidic chip according to claim 1, wherein the height of the step barrier is greater than one CPG and less than 5 µm.

5. The method for manufacturing a microfluidic chip according to claim 1, wherein in step S66, the photosensitive resin is cured and molded into a horizontal sheet shape, a vertical sheet shape, or a grid shape.

6. The method for manufacturing a microfluidic chip according to claim 5, wherein in step S66, the photosensitive resin is cured into a multi-layer horizontal sheet shape, comprising: completing the curing of an underlying photosensitive resin and the CPG carrier through step S65 and step S66 to form a cured bottom layer; and then repeating step S65 and step S66 to perform sequential layer-by-layer curing on the cured bottom layer.

7. The method for manufacturing a microfluidic chip according to claim 1, wherein the CPG carrier is at least one of microporous glass beads and microporous magnetic beads.
